# EUROPEAN PATENT APPLICATION

(11) **EP 3 045 923 A1**
(43) Date of publication of application: **20.07.2016**
(21) Application number: 16150198.6
(22) Date of filing: 05.01.2016
(51) Int. Cl.: G01R 31/00, H02M 3/10, H02M 7/00, B60R 16/023, H02J 7/14, G01R 31/36, G06F 9/445

(54) **VEHICLE EXTERNAL ADJUSTABLE VOLTAGE RECTIFIER**

(30) Priority: 08.01.2015 TW 104200330
(71) Applicant: Reduce Carbon Energy Develop Co., Ltd., New Taipei City 238 (TW)
(72) Inventor: CHEN, Fu-Chieh, 238 New Tapei City (TW)
(74) Representative: Brown, Michael Stanley

(57) **Abstract**

A vehicle external adjustable voltage rectifier including an input cable, an output cable, a rectifying device, and a remote control device, the input cable connects the rectifying device to a generator of the motor vehicle, the output cable connects the rectifying device to a starter battery of the motor vehicle, and the remote control device is connected to the rectifying device using a signal cable, and is used to set and operate the rectifying device remotely. The rectifying device includes a rectifying unit, a filter unit, a step-up/down unit, and a control unit. The control unit is a microcontroller unit that is used to detect the output direct current voltage from the step-up/down unit. The remote control device includes a display and a setting key. The remote control device can be used external of the rectifying device to manually control the step-up/down unit and change the output direct current voltage of the rectifying device.

## Description

### BACKGROUND OF THE INVENTION

### (a) Field of the Invention

The present invention relates to a vehicle power supply system, and more particularly relates to a vehicle external adjustable voltage rectifier.

### (b) Description of the Prior Art

A vehicle power supply system is primarily assembled from a generator, a rectifier, and a starter battery. An input terminal of the rectifier is electrically connected to the generator, and an output terminal of the rectifier is electrically connected to the starter battery.

The engine of a motor vehicle activates the generator, which then operates to generate alternating current. The rectifier rectifies and filters the alternating current to convert it into direct current, which then is supplied to the starter battery and the aforementioned electrical equipment. The starter battery is primarily used to supply the electric energy requirements of the starter motor of the motor vehicle and electrical equipment of the motor vehicle, including the vehicle lighting, and the like.

When the generator is not operating, or the rectifier is not able to fully meet the electrical requirements of the aforementioned electrical equipment, then the starter battery is also able to supply electrical energy to the aforementioned electrical equipment.

Existing vehicle rectifiers are primarily assembled from a rectifier filer unit and a step-down unit, wherein the rectifier filer unit is used to rectify and filter the alternating current from the generator to convert it into direct current. The step-down unit is used to carry out step-down processing of direct current voltage to enable the output of direct current voltage to comply with the charging voltage specifications of the starter battery.

Existing vehicle rectifiers are only able to output direct current voltage rating. And the configuration of the generator and the rectifier is such that they both meet the electrical requirements of the electrical equipment when the vehicle leaves the factory. However, the vehicle owner modifying or adding further electrical equipment to the vehicle, resulting in an increase in the entire electrical requirements, is often the cause for the insufficient output current of the rectifier, causing the starter battery to be often in a state with insufficient electric storage. On the one hand, such a state affects the serviceable life of the starter battery and the electrical equipment, and on the other hand, possibly results in the starter battery being unable to provide sufficient electric power to enable the starter motor to start the engine,

Furthermore, when the electric storage of the starter battery is insufficient, the starter motor of the motor vehicle is unable to provide sufficient torsion to start the engine for it to run, even to the extent of being completely unable to start the starter motor. Moreover, phenomena connected to the problem of insufficient power supply may also possibly affect the electrical equipment (such as: fading in the brightness of the car lights or reduction in the sound volume of the car horn). Hence, apart from resulting in malfunctioning of the starter battery itself or its serviceable life coming to an end because of the insufficient electric storage in the starter battery, this may also be a potential factor attributing to malfunctioning of the generator or the rectifier. However, because the starter battery is a consumable part of the motor vehicle under normal usage, whereas the generator and the rectifier, in contrast to the starter battery, do not generally easily break down. Moreover, these two parts have a long serviceable life. Under general conditions, when phenomena such as the aforementioned starter motor is unable to start the engine or there is insufficient power supply to the electrical equipment, the user usually determines that the starter battery is the cause of the problem, and adopts the measure of replacing the starter battery to resolve the problem. However, within a short period of time, the phenomena reoccurs, that is, difficulty in starting the engine and insufficient power supply to the electrical equipment, creating pointless waste.

### SUMMARY OF THE INVENTION

A primary objective of the present invention lies in providing a vehicle external adjustable voltage rectifier, with which the user is able to adjust the output voltage of a rectifying device according to changes in the electrical equipment of a vehicle resulting in different electrical requirements, thereby enabling a starter battery and the electrical equipment to obtain sufficient supply of electric energy. When phenomena such as the starter motor is unable to start the engine or there is insufficient power supply to the electrical equipment occurs, then the user may determine whether or not there is an anomaly based on an output voltage value displayed on a remote control device and adopt a measure to solve the problem.

The vehicle external adjustable voltage rectifier of the present invention comprises an input cable, an output cable, a rectifying device, and a remote control device, wherein the input cable and the output cable are respectively used to transmit current. The input cable is electrically connected to the rectifying device and the generator of the motor vehicle, and the output cable is electrically connected to the rectifying device and the starter battery of the motor vehicle. The remote control device uses a signal cable to connect to the rectifying device, and is used to set and operate the rectifying device remotely.

The rectifying device comprises a rectifying unit, a filter unit, a step-up/down unit, and a control unit. Wherein the rectifying unit is electrically connected to the filter unit, the step-up/down unit is electrically connected to the filter unit, and the control unit is electrically connected to the step-up/down unit. The rectifying unit is a rectification circuit, which is used to convert the alternating current produced by the generator into direct current. The filter unit is a filter circuit, which is used to smooth the direct current voltage. The step-up/down unit is a step-up/down circuit, which is used to change the direct current voltage to provide the starter battery with electric storage. The control unit is a microcontroller unit, which is used to detect the output direct current voltage from the step-up/down unit, and also controls the step-up/down unit to change the output direct current voltage from the rectifying device.

The remote control device comprises a display and a setting key. The control unit uses the signal cable to transmit information regarding the direct current voltage value of the step-up/down unit to the remote control device. The display is used to display the measured voltage of the control unit, and the setting key is used to operate setting of the output direct current voltage of the step-up/down unit, thereby enabling adjusting and changing the output direct current voltage of the rectifying device.

To enable a further understanding of said objectives and the technological methods of the invention herein, a brief description of the drawings is provided below followed by a detailed description of the preferred embodiments.

### BRIEF DESCRIPTION OF THE DRAWING

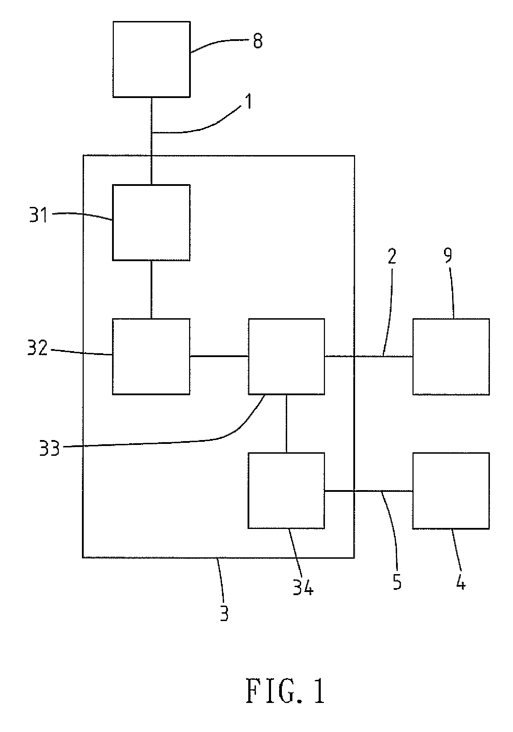

FIG. 1 is a structure block diagram of an embodiment of the present invention.

### DETAILED DESCRIPTION OF THE PREFERRED EMBODIMENT

Referring to Fig. 1, which shows an embodiment of the present invention, comprising an input cable 1, an output cable 2, a rectifying device 3, and a remote control device 4. Wherein the input cable 1 and the output cable 2 are respectively made up from electrical conducting wires and electrical connection terminals, which are used to transmit current. One end of the input cable 1 is electrically connected to the rectifying device 3, and the other end is electrically connected to a generator 8 of a motor vehicle, thereby enabling the generator 8 to operate and generate alternating current that is transmitted to the rectifying device 3 using the input cable 1. One end of the output cable 2 is electrically connected to the rectifying device 3, and the other end is electrically connected to a starter battery 9 of the motor vehicle, thereby enabling the rectifying device 3 to process the aforementioned alternating current into direct current, whereupon the direct current is transmitted to the starter battery 9 using the output cable 2. The remote control device 4 is installed external to the rectifying device 3, and the remote control device 4 is connected to the rectifying device 3 using a signal cable 5. The user operates the remote control device 4 to set and operate the rectifying device 3 remotely.

The rectifying device 3 comprises a rectifying unit 31, a filter unit 32, a step-up/down unit 33, and a control unit 34. Wherein the rectifying unit 31 is electrically connected to the filter unit 32, the step-up/down unit 33 is electrically connected to the filter unit 32, and the control unit 34 is electrically connected to the step-up/down unit 33. The rectifying unit 31 is a rectification circuit, which is used to convert the alternating current produced by the generator 8 into direct current. The filter unit 32 is a filter circuit, which is used to carry out a filtering processing on the direct current processed by the rectifying unit 31 to smooth the direct current voltage. The step-up/down unit 33 is a step-up/down circuit, which is used to convert the direct current processed by the filter unit 32 into a relatively low direct current voltage to provide the starter battery 9 with electric storage. The aforementioned rectifying unit 31, the filter unit 32, and the step-up/down unit 33 are all well known to persons skilled in the field of electronic technology, and thus no detailed description of specific structures is provided herein. The control unit 34 is a microcontroller unit (abbreviated to MCU), which is used to detect the direct current voltage output from the step-up/down unit 33, and also controls the step-up/down unit 33 to change the direct current voltage output by the rectifying device 3.

The remote control device 4 comprises a display and a setting key. The control unit 34 measures the output direct current voltage value from the step-up/down unit 33, and transmits the measurement value to the remote control device 4 using the signal cable 5. The display of the remote control device is used to display the aforementioned direct current voltage value, whereupon the user may use the setting key to operate setting of the output direct current voltage of the step-up/down unit 33, thereby enabling adjusting and changing the output direct current voltage of the rectifying device 3.

The aforementioned embodiment has application in a vehicle power supply system, whereby the user may use the remote control device 4 to know the processed direct current voltage value from the rectifying device 3, and determine whether or not there is an anomaly from the voltage value. The user can then use this information as a basis to determine whether or not the rectifying device 3 or the generator 8 is operating normally. When phenomena such as the starter motor of a motor vehicle is unable to smoothly start the engine or there is insufficient power supply to the electrical equipment occurs, the user is able to accurately determine where the problem lies. If the displayed voltage value on the remote control device 4 falls below a set permissible range, the user can then diagnose that the possible cause for insufficient power supply lies in the generator or the rectifying device, thus preventing the user from jumping to the wrong conclusion and replacing the starter battery 9 by relying only on experience and instincts, culminating in pointless waste.

When the user modifies the motor vehicle or adds further electrical equipment, resulting in an increase or decrease in the entire electrical requirements of the motor vehicle, the user can use the remote control device 4 external of the rectifying device 3 to manually control the step-up/down unit 33 and change the output direct current voltage of the rectifying device 3, thereby enabling the output direct current from the rectifying device 3 to meet the electrical requirements of the motor vehicle without causing an excessive supply of power. Accordingly, undesirable wear and tear on the serviceable life of the starter battery 9 and the electrical equipment of the motor vehicle because of inadequate supply of power producing is prevented.

It is of course to be understood that the embodiments described herein are merely illustrative of the principles of the invention and that a wide variety of modifications thereto may be effected by persons skilled in the art without departing from the spirit and scope of the invention as set forth in the following claims.

## Claims

1. A vehicle external adjustable voltage rectifier, comprising an input cable, an output cable, a rectifying device, and a remote control device, wherein the input cable and the output cable are respectively used to transmit current; the input cable electrically connects the rectifying device to a generator of the motor vehicle; the output cable electrically connects the rectifying device to a starter battery of the motor vehicle; the remote control device is connected to the rectifying device using a signal cable, and the remote control device is used to set and operate the rectifying device remotely;
the rectifying device comprises a rectifying unit, a filter unit, a step-up/down unit, and a control unit, wherein the rectifying unit is electrically connected to the filter unit, the step-up/down unit is electrically connected to the filter unit, and the control unit is electrically connected to the step-up/down unit; the rectifying unit is a rectification circuit that is used to convert the alternating current produced by the generator into direct current; the filter unit is a filter circuit that is used to smooth the direct current voltage; the step-up/down unit is a step-up/down circuit that is used to change the direct current voltage to provide the starter battery with electric storage; and the control unit is a microcontroller unit that is used to detect the output direct current voltage from the step-up/down unit, and also controls the step-up/down unit to change the direct current voltage output by the rectifying device;
the remote control device comprises a display and a setting key; the control unit transmits information regarding the direct current voltage value output from the step-up/down unit to the remote control device using the signal cable; the display is used to display the measured voltage from the control unit; the setting key is used to operate setting of the output direct current voltage from the step-up/down unit, thereby enabling adjusting and changing the output direct current voltage from the rectifying device.
